(19) Europäisches Patentamt
European Patent Office
Office européen des brevets

(11) **EP 1 801 607 A2**

(12) **EUROPEAN PATENT APPLICATION**

(43) Date of publication:
**27.06.2007 Bulletin 2007/26**

(51) Int Cl.:
***G01R 33/44*** *(2006.01)*

(21) Application number: **07005450.7**

(22) Date of filing: **08.03.1999**

(84) Designated Contracting States:
**BE CH DE FR GB IT LI NL SE**

(30) Priority: **06.03.1998 GB 9804932**

(62) Document number(s) of the earlier application(s) in accordance with Art. 76 EPC:
**99937992.8 / 1 060 404**

(71) Applicant: **BTG INTERNATIONAL LIMITED**
**London EC4M 7SB (GB)**

(72) Inventors:
 • **Rowe, Michael David**
  **London W4 2HU (GB)**

 • **Smith, John Alec**
  **London SW19 7QR (GB)**

(74) Representative: **Cozens, Paul Dennis et al**
 **Mathys & Squire**
 **120 Holborn**
 **London EC1N 2SQ (GB)**

Remarks:
 This application was filed on 16 - 03 - 2007 as a divisional application to the application mentioned under INID code 62.

(54) **NQR testing method and apparatus**

(57) An apparatus for and method of Nuclear Quadrupole Resonance testing a sample are disclosed. The technique comprises applying excitation to the sample to excite nuclear quadrupole resonance at a plurality of different nuclear quadrupole resonance frequencies, detecting the resonance responses to the excitation at the plurality of frequencies, and processing the resonance responses at the plurality of frequencies to yield a combined response. The combined response may have a signal to noise ratio larger than that of any individual response.

Fig.7.

EP 1 801 607 A2

**Description**

The present invention relates to a method of and apparatus for Nuclear Quadrupole Resonance testing a sample. The testing may involve, for example, detecting the presence of a specific substance, or imaging.

Nuclear Quadrupole Resonance (NQR) testing is used for testing specific substances such as polycrystalline substances. It depends on the energy levels of quadrupolar nuclei, which have a spin quantum number I greater than ½, of which $^{14}$N is an example (I = 1). $^{14}$N nuclei are present in a wide range of substances, including animal tissue, bone, food stuffs, explosives and drugs. One particular use of the technique of the present invention is in the detection of the presence of substances such as explosives or narcotics. The detection may be of baggage at airports, or of explosives or drugs concealed on the person or buried underground or elsewhere.

In conventional NQR testing a sample is placed within or near to a radio-frequency (rf) coil and is irradiated with pulses or sequences of pulses of electro-magnetic radiation having a frequency which is at or very close to a resonance frequency of the quadrupolar nuclei in a substance which is to be tested. If the substance is present, the irradiant energy will generate a processing magnetization which can induce voltage signals in a coil surrounding the sample at the resonance frequency and which can hence be detected as a free induction decay (f.i.d.) during a decay period after each pulse or as an echo after two or more pulses.

It is known that certain substances may display two or more NQR resonance frequencies. UK Patent Application No. GB 2286248 in the name of British Technology Group Limited discloses a technique in which two or more NQR resonance frequencies are excited and the response at each of the frequencies is detected individually. An alarm signal is generated if all of the resonance frequencies are detected above a given noise threshold.

The technique of GB 2286248 works well in situations where two or more distinct NQR resonances are readily detectable individually. However, certain substances do not display such well defined NQR characteristics. Indeed certain substances such as TNT have up until now been considered as being undetectable by practically feasible NQR tests, mainly because of the low signal to noise ratio (SNR) characteristics of their various lines.

It has been discovered pursuant to the present invention that chemical differences or crystallographic non-equivalences that occur in substances such as TNT may cause these substances to display a relatively large number of weak NQR resonances. These resonances may accordingly be extremely difficult to detect. It is an aim of the present invention to improve the detectability of such substances. It is another aim of the present invention to improve the signal to noise ratio of the NQR response signals of such substances.

According to a first aspect of the present invention there is provided apparatus for nuclear quadrupole resonance testing a sample, comprising applying means (such as an antenna, which may be a coil antenna) for applying excitation to the sample to excite nuclear quadrupole resonance at a plurality of different nuclear quadrupole resonance frequencies, detecting means (such as an antenna, which may be the same antenna as the applying means) for detecting the resonance responses to the excitation at the plurality of frequencies, and processing means (such as a computer) for processing the resonance responses at the plurality of frequencies to yield a combined response.

The effect of the processing is to yield a combined response (which incorporates the responses from the plurality of different nuclear quadrupole resonance response frequencies) for which the signal to noise ratio can be higher than for any one individual response. The apparatus may therefore afford the advantage that the signal to noise ratio of the response may be increased sufficiently to allow the testing of a sample which would otherwise be difficult or even impossible to test.

The processing means may be adapted to process the resonance responses such that their frequencies would appear shifted towards one another (and combined) in the frequency domain.

The processing means may be adapted to have the effect of shifting a respective resonance response peak (in other words, the peak in the frequency domain) associated with each said resonance response towards one another to yield as the combined response a response having a smaller number of peaks; the combined response may have a smaller number of peaks (preferably only one peak) than the number of individual resonance response peaks. The peaks of the combined response may have a greater intensity than those of the response responses prior to processing. There may be more than one individual resonance response peak per resonance response. Not all peaks may be so shifted.

As discussed later, the appearance or effect of frequency shifting may be achieved by actual frequency shifting, or by techniques which have that effect.

The processing means may be adapted to process the resonance responses such that their frequencies would appear superposed in the frequency domain. For example, the processing means may be adapted to process the resonance responses such that their frequencies would appear substantially to coincide in the frequency domain.

The processing means may be adapted to process the resonance responses such that their frequencies would appear shifted in the frequency domain, and to combine the thus processed resonance responses to yield the combined response. The resonance responses may be combined in any way which causes the combined response to have a larger signal than that of any individual response. For example, the processing means may be adapted to sum the thus processed resonance responses to yield the combined response, by which will be appreciated that summing includes, for example, the subtraction of signals of opposite phase. The processing means may be adapted to shift the frequencies of the resonance responses such that they superpose. By this it is preferably meant that the frequencies of the resonance responses are shifted such that they overlap to such a degree that combining the thus shifted resonant responses yields a combined response having a larger signal than that of any individual response. For example, the processing means may be adapted to shift the frequencies of the resonance responses such that they substantially coincide.

The processing means may comprise means for demodulating or deconvoluting the resonance responses to yield the combined response. For example, the processing means may comprise a filter, matched to expected frequencies of the resonance response signals, for filtering the resonance response signals, in which case the processing means may further comprise means for transforming the filtered signals into the frequency domain,

As another example, the processing means may comprise means for performing a maximum entropy deconvolution technique. The maximum entropy deconvolution technique may be a maximum entropy method which includes a filter matched to expected frequencies of the resonance response signals, or the maximum entropy deconvolution technique may be quantified maximum entropy ("MaxEnt") deconvolution, as supplied by MaxEnt Solutions Limited of Isleham, Ely, Cambridgeshire, UK.

In a further example, the processing means may comprise a phase sensitive detector.

The processing means may alternatively be adapted to transform the resonance responses into the frequency domain, to shift the frequencies of the thus transformed resonance responses, and to combine the thus shifted resonance responses to yield the combined response.

The apparatus may further comprise determining means for determining predetermined values of nuclear quadrupole resonance frequencies. The predetermined values of nuclear quadrupole resonance frequencies may correspond to anticipated (expected) values of resonance frequencies in the substance to be tested, and thus the predetermined values may be used in determining appropriate excitation and/or in processing the resonance responses. Thus, the processing means may be adapted to process the resonance responses in dependence on the predetermined values of nuclear quadrupole resonance frequencies. For example, knowledge of the predetermined values of nuclear quadrupole resonance may be used to shift the frequencies of the resonance responses in the frequency domain, or to demodulate or deconvolute the resonance responses. In particular, knowledge of the predetermined values of nuclear resonance may be used to effect phase sensitive detection, or to perform a maximum entropy deconvolution technique, or to provide a filter matched to expected frequencies of the resonance response signals. Thus, prior knowledge of the absolute and relative frequencies of the resonance response from the various lines may be used to "collapse" the various responses (such as a doublet or multiplet) to a single line (a singlet), having a single peak in the frequency domain.

The apparatus may further comprise means for sensing an environmental parameter, such as temperature or pressure, and the determining means may be adapted to determine the predetermined values of nuclear quadrupole resonance frequencies in dependence on known variations of nuclear quadrupole resonance frequencies with the environmental parameter. The determining means may be adapted to determine the predetermined values of nuclear quadrupole resonance frequencies using a polynomial fit or a look-up table.

In the particular case of TNT, it has been discovered pursuant to the present invention that for the temperature range of interest the resonances exhibit a linear temperature dependence, and therefore, if the substance to be tested is TNT, the determining means may be adapted to determine the predetermined values of nuclear quadrupole resonance frequencies substantially according to the following formula

$$\upsilon_Q = \upsilon_0 - a\,T$$

where $\upsilon_Q$ is the frequency to be selected, $T$ is temperature and $\alpha$ and $\upsilon_0$ are selected from the following table:-

| $\upsilon_0$/kHz | $\alpha$/kHzT$^{-1}$ |
| --- | --- |
| 901 | 0.10 |
| 921 | 0.21 |
| 894 | 0.15 |
| 876 | 0.11 |
| 893 | 0.17 |
| 870 | 0.11 |
| 821 | 0.18 |

(continued)

| $\upsilon_o$/kHz | $\alpha$/kHzT$^{-1}$ |
|---|---|
| 820 | 0.23 |
| 783 | 0.14 |
| 787 | 0.16 |
| 740 | 0.09 |
| 741 | 0.09 |

Alternatively, in the case of RDX, the predetermined values of nuclear quadrupole resonance frequencies may comprise 1783 kHz and 1786 kHz at 286 K. These values may be adjusted where appropriate in dependence on the environmental temperature and/or pressure.

The applying means may be adapted to apply excitation at the predetermined values of nuclear quadrupole resonance frequencies. This may allow the excitation to be maximised in frequency bands corresponding to the resonance response frequencies of the substance under test, which may result in a better signal to noise ratio of the detected response.

In a first preferred embodiment, the applying means is adapted to apply excitation to excite the plurality of nuclear quadrupole resonance frequencies sequentially (possibly in repeating series). In this case, a plurality of pulse sequences may be applied, each of a frequency corresponding to one of the resonance frequencies of the substance under test. This may allow the frequencies of the excitation to correspond closely to the resonance frequencies of the substance, which may increase the signal to noise ratio of the detected response.

In the first preferred embodiment, the processing means may be adapted to sum the responses to the excitation to yield a summed response, and to process the summed response to yield the combined response, or alternatively the processing means may be adapted to shift the frequencies of the responses to the excitation to yield frequency shifted responses, and to sum the frequency shifted responses to yield the combined response.

Alternatively the applying means may be adapted to apply excitation at the predetermined values of nuclear quadrupole resonance frequencies simultaneously. The applying means may then be adapted to apply excitation pulses with a bandwidth including the predetermined values of nuclear quadrupole resonance frequencies.

In a second preferred embodiment, the applying means is adapted to apply excitation pulses which exhibit at least two peaks in the frequency domain. The peaks may correspond to the predetermined values of nuclear quadrupole resonance frequencies, that is, to expected values of the resonance response frequencies. In this way the excitation may be tailored to concentrate the excitation as far as possible around the resonance frequencies of the substance, which may improve the signal to noise ratio of the detected response.

In a third preferred embodiment the applying means is adapted to apply excitation pulses which have a single peak in the frequency domain but which exhibit a bandwidth wide enough to include the predetermined values of nuclear quadrupole resonance.

The techniques of any of the three preferred embodiments may be used in combination with either of the other preferred embodiments. Therefore in the second or third preferred embodiments the applying means may be adapted to apply further excitation sequentially at at least one further predetermined nuclear quadrupole resonance frequency.

The applying means may be adapted to apply a plurality of excitation pulses, the time between successive excitation pulses being less than 5 times the $T_1$ value of the nuclear quadrupole resonance (that is, the value of $T_1$ of the quadrupolar nuclei in the sample, or that of at least one of the lines of the quadrupolar nuclei), preferably less than 3, 2, 1, 0.5, 0.3, 0.2 or 0.1 times.

Where the excitation at the different frequencies is applied sequentially, the plurality of excitation pulses may be pulses at the different excitation frequencies. However, a plurality of excitation pulses may also be applied at each of the excitation frequencies. Where the excitation at the different frequencies is applied simultaneously, a plurality of excitation pulses, each covering the excitation frequencies of interest, may be applied. This feature can allow the responses from a plurality of excitation pulses to be accumulated, which can improve the reliability of the testing.

By providing that the time between successive excitation pulses is less than 5 times the $T_1$ value of the nuclear quadrupole resonance, the time taken for such tests can be reduced. This is an important feature, since previously it was considered that a time of greater than 5 times $T_1$ should be left between the successive pulses, in order to allow full signal recovery between pulses. However, it has now been discovered pursuant to the present invention that pulse repetition times of less than $T_1$ can in fact be used in certain circumstances.

A consequence of having a pulses repetition time of less than $T_1$ is that signal from one response may leak through into the signal from another response; however, in the context of detection, this phenomenon can still allow a signal to be produced which is indicative of the presence of a particular substance.

The applying means may comprise a plurality of antennas, and each antenna may be tuned to a different resonant frequency. Each antenna may be adapted to apply excitation at a single frequency or at a plurality of frequencies. For example, the applying means may comprise a doubly or triply tuned antenna adapted to excite two or more groups of lines simultaneously.

The detecting means may comprise a plurality of antennas, each of which may be runed to a different frequency.

The apparatus may further comprise means for providing an alarm signal in dependence upon the combined response, for example in dependence upon whether the combined response exceeds a predetermined threshold.

The apparatus may be apparatus for detecting the presence of a substance containing a given species of quadrupolar nucleus.

It is desirable to excite (as far as practicable) as many as possible of the lines of the substance under test, in order to improve the signal to noise ratio. Thus the means for applying excitation may be adapted to apply excitation at at least 2,4,6,8,10 or 12 different frequencies. For example, the means for applying excitation may be adapted to apply excitation at the frequencies of at least 10%, 20%, 30%, 50%, or 75 % of the lines of the substance under test (especially the $^{14}$N lines).

An important aspect of the present invention is the discovery of the nuclear quadrupole resonance lines of TNT and thus the applying means may be adapted to apply excitation to excite a plurality of resonances selected from the following table:-

| FREQUENCY AT 293K/kHz |
|---|
| 870 |
| 859 |
| 848 |
| 844 |
| 843 |
| 837 |
| 769 |
| 751 |
| 743 |
| 739 |
| 714.3 |
| 713.7 |

Therefore, in a related aspect of the present invention, there is provided apparatus for detecting the presence in a sample of a substance containing quadrupolar nuclei, comprising applying means for applying to the sample excitation to excite a plurality of resonances selected from the following table:-

| FREQUENCY AT 293K/kHz |
|---|
| 870 |
| 859 |
| 848 |
| 844 |
| 843 |
| 837 |
| 769 |
| 751 |
| 743 |

(continued)

| FREQUENCY AT 293K/kHz |
| --- |
| 739 |
| 714.3 |
| 713.7 |

In particular, the applying means may be adapted to excite at least one of (preferably two, three or all four of) the 843 kHz, the 844 kHz, the 739 kHz and the 713.7 kHz resonances.

The applying means may be adapted to apply excitation to excite (some or all of) the resonances in at least one of the following groups;-

| GROUP | FREQUENCY AT 293K/kHz | | | |
| --- | --- | --- | --- | --- |
| 1 | 837 | 843 | 844 | 848 |
| 2 | 859 | 870 | | |
| 3 | 739 | 743 | 751 | |
| 4 | 713.7 | 714.3 | | |

The frequencies of the resonances within a group are relatively close together, and therefore exciting some or all of the resonances within a group may allow the resonances to be excited without the need for re-tuning the rf probe.

The apparatus may comprise storage means for storing values of NQR resonances. This may allow the apparatus to apply excitation corresponding to the plurality of resonances.

The apparatus may comprise determining means for determining values of NQR resonances. The apparatus further comprise-means for sensing an environmental parameter such as temperature or pressure. The determining means may then be adapted to determine the values of NQR resonances in dependence on the environmental parameter. This may be done by using a look up table, or a polynomial fit of variations of NQR resonances with the environmental parameter.

The apparatus may further comprise means for detecting the resonance responses to the excitation, and means for providing an alarm signal in dependence on the detected response.

According to a method aspect of the present invention there is provided a method of Nuclear Quadrupole Resonance testing a sample, comprising applying excitation to the sample to excite nuclear quadrupole resonance at a plurality of different nuclear quadrupole resonance frequencies, detecting the resonance responses to the excitation at the plurality of frequencies, and processing the resonance responses at the plurality of frequencies to yield a combined response.

The step of processing may comprise processing the resonance responses such that their frequencies would appear shifted towards one another in the frequency domain.

The step of processing may have the effect of shifting a respective resonance response peak associated with each said resonance response towards one another to yield as the combined response a response having a smaller number of peaks.

The step of processing may comprise processing the resonance responses such that their frequencies would appear superposed in the frequency domain. The step of processing may comprise processing the resonance responses such that their frequencies would appear substantially to coincide in the frequency domain. The step of processing may comprise demodulating or deconvoluting the resonance responses to yield the combined response.

The step of processing may comprises filtering the resonance responses with a filter matched to expected frequencies of the resonance responses. The step of processing may then further comprise transforming the filtered signals into the frequency domain.

The step of processing may comprise performing a maximum entropy deconvolution technique. The maximum entropy deconvolution technique may be a maximum entropy method which includes a filter matched to expected frequencies of the resonance response signals, or it may be quantified maximum entropy ("MaxEnt") deconvolution.

The step of processing may comprise phase sensitive detection.

The step of processing may comprise transforming the resonance responses into the frequency domain, shifting the frequencies of the thus transformed resonance responses, and combining the thus shifted resonance responses to yield the combined response.

The method may further comprise determining predetermined values of nuclear quadrupole resonance frequencies. The step of processing may then comprise processing the resonance responses in dependence on the predetermined values of nuclear quadrupole resonance frequencies. The method may further comprise sensing an environmental parameter, and the step of determining may comprise determining predetermined values of nuclear quadrupole resonance frequencies in dependence on known variations of nuclear quadrupole resonance frequencies with the environmental parameter. The step of determining may comprise determining the predetermined values of nuclear quadrupole resonance frequencies using a polynomial fit or a look-up table.

The step of determining may comprise determining the predetermined values of nuclear quadrupole resonance frequencies substantially according to the following formula

$$\upsilon_Q = \upsilon_0 - \alpha\, T$$

where $\upsilon_Q$ is the frequency to be selected, $T$ is temperature and $\alpha$ and $\upsilon_0$ are selected from the following table:-

| $\upsilon_0$/kHz | $\alpha$/kHzT$^{-1}$ |
|---|---|
| 901 | 0.10 |
| 921 | 0.21 |
| 894 | 0.15 |
| 876 | 0.11 |
| 893 | 0.17 |
| 870 | 0.11 |
| 821 | 0.18 |
| 820 | 0.23 |
| 783 | 0.14 |
| 787 | 0.16 |
| 740 | 0.09 |
| 741 | 0.09 |

In the case of RDX, the predetermined values of nuclear quadrupole resonance frequencies may comprise 1783 kHz and 1786 kHz at 286 K, adjusted where necessary in dependence on environmental conditions.

The step of applying excitation may comprise applying excitation at the predetermined values of nuclear quadrupole resonance frequencies.

The step of applying excitation may comprise applying excitation to excite the plurality of nuclear quadrupole resonance frequencies sequentially. The step of processing may then comprise summing the responses to the excitation to yield a summed response, and processing the summed response to yield the combined response, or the step of processing may comprise shifting the frequencies of the responses to said excitation to yield frequency shifted responses, and summing the frequency shifted responses to yield the combined response.

The step of applying excitation may comprise applying excitation at the predetermined values of nuclear quadrupole resonance frequencies simultaneously. The step of applying excitation may comprise applying excitation pulses with a bandwidth including the predetermined values of nuclear quadrupole resonance frequencies. The step of applying excitation may comprise applying excitation pulses which exhibit at least two peaks in the frequency domain. The step of applying excitation may comprise applying further excitation sequentially at at least one further predetermined nuclear quadrupole resonance frequency.

The step of applying excitation may comprise applying a plurality of excitation pulses, the time between successive excitation pulses being less than 5 times the $T_1$ value of the nuclear quadrupole resonance, preferably less than 3, 2, 1, 0.5, 0.3, 0.2 or 0.1 times.

The method may further comprise providing an alarm signal in dependence upon the combined response,

The method may be a method of detecting the presence of a substance containing a given species of quadrupolar nucleus.

The step of applying excitation may comprise applying excitation to excite a plurality of resonances selected from the following table:-

| FREQUENCY AT 293K/kHz |
| --- |
| 870 |
| 859 |
| 848 |
| 844 |
| 843 |
| 837 |
| 769 |
| 751 |
| 743 |
| 739 |
| 714.3 |
| 713.7 |

In a closely related method aspect there is provided a method of detecting the presence in a sample of a substance containing quadrupolar nuclei, comprising applying to the sample excitation to excite a plurality of resonances selected from the following table:-

| FREQUENCY AT 293K/kHz |
| --- |
| 870 |
| 859 |
| 848 |
| 844 |
| 843 |
| 837 |
| 769 |
| 751 |
| 743 |
| 739 |
| 714.3 |
| 713.7 |

The step of applying excitation may comprise exciting at least one of the 843 kHz, the 844 kHz, the 739 kHz and the 713.7 kHz resonances.
The step of applying excitation may comprise applying excitation to excite the resonances in at least one of the following groups:-

| GROUP | FREQUENCY AT 293K/kHz | | | |
| --- | --- | --- | --- | --- |
| 1 | 837 | 843 | 844 | 848 |
| 2 | 859 | 870 | | |
| 3 | 739 | 743 | 751 | |
| 4 | 713.7 | 714.3 | | |

The method may further comprise storing values of NQR resonances. The method may further comprise determining values of NQR resonances. The method may further comprise sensing an environmental parameter. The step of determining may comprise determining the values of NQR resonances in dependence on the environmental parameter.

The method may further comprise detecting the resonance responses to the excitation, and providing an alarm signal in dependence on the detected response.

Apparatus features may be applied to method aspects and *vice versa*, similarly, features from one aspect of the invention may be applied to other aspects of the invention.

Preferred features of the present invention will now be described, purely by way of example, with reference to the accompanying drawings, in which:-

Figure 1 is a plot of the TNT NQR $\nu_+$ line frequency temperature dependence;
Figure 2 is a plot of the TNT NQR $\nu_-$ line frequency temperature dependence;
Figures 3 illustrate the operation of a first preferred embodiment;
Figure 4a shows an example of a composite pulse that produces a doublet frequency response;
Figure 4b shows the frequency response of the pulse of Figure 4a;
Figure 5 is a plot of $T_1$ temperature dependence for the TNT 870.3 kHz line;
Figure 6 shows an NQR testing apparatus;
Figure 7 is a flow diagram of a preferred method embodiment; and
Figure 8 is a flow diagram of a maximum entropy method.

## Characteristics of TNT

Lengthy investigations into the NQR frequencies of TNT have been conducted pursuant to the present invention. Twelve resonances or lines have been observed at room temperature.

It has been found that for the temperature ranges of interest the frequencies of TNT follow the equation

$$\nu_Q = \nu_0 - a\,T \qquad\qquad (1)$$

where $\nu_0$ is the frequency at absolute zero, $a$ is the temperature coefficient and $T$ is temperature.

For the twelve lines of interest (six $\nu_+$ and six $\nu_-$) the coefficients $\nu_0$ and $\alpha$ are given in Table 1. Each line is classified according to its observed frequency at room temperature ($^-$293 K). It should be noted that the same order will not necessarily be observed at other temperatures since there are several cross-overs in the frequency/temperature plots in the region of interest.

**Table 1**

| LINE FREQUENCY AT 293 K/kHz | | $\nu_0$/kHz | $\alpha$/kHzT$^{-1}$ |
|---|---|---|---|
| $\nu_x$ | 870.3 | 900.663 | 0.1030 |
| | 859.4 | 921.184 | 0.2102 |
| | 848.3 | 893.502 | 0.1529 |
| | 844.2 | 875.734 | 0.1070 |
| | 842.8 | 892.503 | 0.1685 |
| | 837.1 | 870.293 | 0.1125 |
| $\nu_y$ | 768.8 | 821.478 | 0.1787 |
| | 750.6 | 819.985 | 0.2334 |
| | 742.6 | 782.809 | 0.1352 |
| | 739.2 | 786.501 | 0.1590 |
| | 714.3 | 740.363 | 0.0879 |
| | 713.7 | 741.139 | 0.0924 |

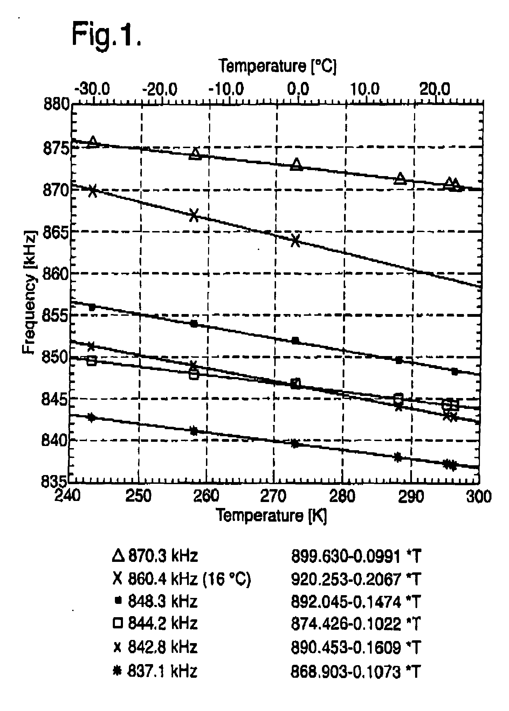

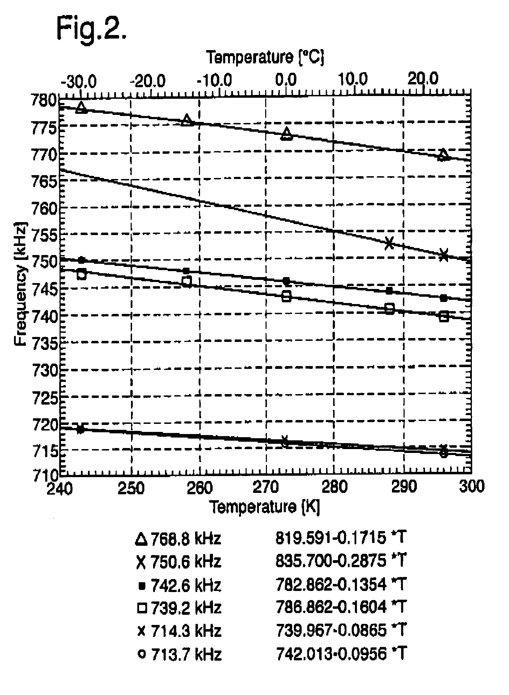

The frequency information is plotted in Figures 1 and 2 for the $\upsilon_+$ and $\upsilon_-$ regions respectively. As the 844.2 and 842.8 kHz lines are close together the data for each has been assigned under the assumption that the plots are straight lines crossing at 273 K. It should be noted that a linear temperature dependence is an assumption and will not necessarily hold for other substances or over different temperature ranges.

It has been recognised pursuant to the present invention that practical testing of TNT and other substances displaying similar characteristics may be possible by exciting as many as possible of the NQR lines in the substance and by using appropriate processing techniques to analyse the detected response.

**First Preferred Embodiment**

In a technique according to a first preferred embodiment, as many NQR lines as possible in a substance are excited sequentially and the responses from the sequential excitations are detected. The individual responses are then processed to give a combined response. The combined response is analysed to detect the presence of the substance.

Each line is excited by applying a sequence of excitation pulses at the frequency of that line, taking into account the temperature of the sample. For example, if TNT is to be detected, the frequency of each line could be calculated by using equation (1) above and the coefficients given in Table 1, or a look-up table. If a substance other than TNT were to be detected, the appropriate coefficients or look-up table for that substance would be used instead. For each line, the sequence may be the same as, or different from, the sequence used for the other lines. As will be discussed later, the temperature of the sample will also affect the relaxation times of quadrupolar nuclei in the sample, and the pulse sequences can be designed to take this into account.

In certain circumstances the temperature of the sample may not be known exactly. For example, if the sample is buried in the ground, the temperature of the sample will depend on various factors such as depth, soil type, and time of day. In this case it may not be sufficient merely to measure the surface temperature of the soil. One option is to insert a probe into the soil to measure the temperature at the expected depth of the sample. Another option is to use a processing technique to estimate the temperature of the soil at the expected depth of the sample given the surface or ambient temperature. A suitable technique for this purpose is described by Hanks et al in "Soil Temperature Estimation by a Numerical Method", Soil Science Society of America Proceedings, Vol. 35, No. 5, September-October 1971, the subject matter of which is incorporated herein by reference. This article describes how soil temperatures may be predicted at different depths using knowledge of the soil's thermal properties.

The individual responses to the excitation are summed to give a summed response. The responses may be summed in any way. For example different weightings may be given to different responses in relation to the strength of the resonance. It may also be necessary to take into account any influence from the excitation of other lines.

The summed response is then processed to yield a combined response, in which the various NQR responses are "collapsed" into a single line in the frequency domain. This is achieved by using prior knowledge of the expected frequencies of the NQR responses to shift the frequencies of the responses such that the responses from all lines coincide and combine at a single arbitrary line in the frequency domain. For example, any demodulation or deconvolution technique may be used to achieve this.

In one example, a phase sensitive detector is used. The phase sensitive detector demodulates each line so that all lines coincide at an arbitrary line in the frequency domain, which may be at the origin or any other point. Preferably, it is arranged that the lines coincide at a frequency which is off-resonant to all lines in the spectrum, and is offset from the origin, to avoid break-through at the origin. The coincident lines are additively combined so as to yield a response that is stronger with respect to noise than any individual line.

In another example, the summed response is Fourier transformed into the frequency domain and each of the lines is frequency shifted such that the lines coincide. Again, the coincident lines are additively combined so as to yield a response that is stronger with respect to noise than any individual line.

In another example, a matched filter is applied to the time domain data, the filter representing the expected spectrum of the resonance response signal (in the absence of noise), and the resultant signal is Fourier transformed into the frequency domain. The matched filter is established using the prior information concerning the frequencies of the resonance response signals. If there were just one frequency $\omega$, the matched filter would take the form (for echo responses):

$$f(j,t) = \exp[-B(t+j\tau)]\exp(-C|t|)\exp(-i\omega t)$$

for the $j^{\text{th}}$ response (for example, an echo), where t is time, $\tau$ is the spacing between echoes and B and C are decay constants for the individual echo and the echo train respectively. For f.i.d.'s, $\tau=0$.

In the case where there are multiple frequencies, $\Omega_k$, in the spectrum, which are all in phase at the peak of the signal, and have amplitudes $A_k$, then the filter $f(j,t)$ has the same form as the complex conjugate of the signal;

$$f(j,t) = \sum A_k \exp[-B_k(t+j\tau)]\exp(-C_k|t|)\exp(-i\Omega_k t)$$

The filter is used to modify the signal in the time domain. Fourier transformation then produces a singlet in the frequency domain in which all k responses are combined. In this way, prior knowledge of the frequencies at which the resonance response signals occur can be used to combine the signals in such a way that the signal to noise ratio is increased.

In a further example, maximum entropy deconvolution using the maximum entropy method, in which each line is deconvolved to a single line, is used to produce the combined response. Such a technique will be described later.

Another (related) technique, quantified maximum entropy, known as "MaxEnt" could also be used. This can operate directly on the frequency domain spectrum making use of any prior knowledge, and produces a solution containing the minimum structure consistent with the raw data.

If the combined response exceeds a predetermined threshold an alarm signal is generated to indicate the presence of the substance. It should be noted that the response from any one particular line may be lost in noise and hence undetectable, but the combination of all of the responses in the frequency domain may produce a signal that is strong enough to be detected.

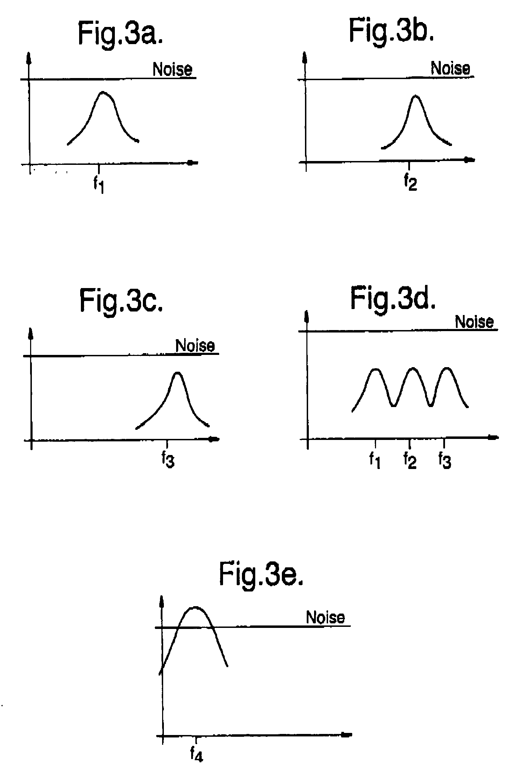

The operation of the first preferred embodiment is illustrated diagrammatically in Figures 3. Figures 3a-3c show representations of three NQR response signals in the frequency domain, at frequencies $f_1$, $f_2$ and $f_3$ respectively. Each signal is below the noise level, and hence undetectable individually. According to the first preferred embodiment the three response signals are first summed, as shown in Figure 3d, and then combined at a fourth frequency $f_4$ to yield a combined response in as shown in Figure 3e. Combining the various NQR responses at the same line in the frequency domain results in a signal that is above the noise level and hence detectable. In practical situations, as many as possible of the NQR lines of the substance under test would be combined.

In a variant of the first preferred embodiment, each of the responses is first shifted in the frequency domain such that the NQR response from each line is at substantially the same frequency, and the frequency shifted responses are then summed to yield the combined response. Again, prior knowledge of the expected frequencies of the NQR responses is used to ensure that the responses are frequency shifted such that their frequencies substantially coincide.

If a wide range of lines are to be excited, the rf probe may need to be retuned and the matching to the transmitter adjusted for different frequencies, or a multiply tuned rf probe may be used. However, for a more closely grouped selection of lines, this may not be necessary. The selection of which lines to excite therefore depends on a number of factors including the relative strength of the resonance and proximity to other lines of interest.

At each frequency, the effective Q-factor of the coil should ideally be as high as possible, and the coil may need to be adjusted to take into account different environmental conditions such as terrain. To further optimise SNR, Q-enhancing methods such as cooling the antenna and preamplifier may be used, or high $T_e$ superconducting rf coils may be used.

In the first preferred embodiment a single probe may be used for the excitation and detection, or alternatively two or more probes may be used for the excitation and/or the detection. For example a pair of coils in the Helmholtz configuration may be used or a coil array such as that disclosed in UK Patent Application No. GB 2289344 in the name of British Technology Group Limited, the subject matter of which is incorporated herein by reference, may be used.

For example, a number of coils equal to the number of lines to be excited may be used, each coil being cyclically subjected to each of the excitation frequencies in turn (adjusted to the temperature of the object). At any one time each coil will then be testing one area at one frequency, the area and frequency being different from the area and frequency of the other coils. Applying different frequencies to different coils at any one time reduces the interaction between the different excitations. This technique allows a wider area to be tested and the time for testing to be filled efficiently.

In the case of TNT an array of up to twelve coils could be used, each of which is cyclically subjected to each of the twelve excitation frequencies in turn so that coil 1 for example "sees" the 870.3 kHz line while at the same time coil 12 "sees" the 713.7 kHz line, and so on.

To avoid the need for switching so many coils, in another variant, a receiver coil array may be used with one transmitter coil whose frequency is cycled through all selected frequencies. The cycle is conducted in such a way that the array "sees" the same frequency again after 12 such switches, the total time between those two events being set as close as possible while allowing sufficient spin-lattice relaxation to occur in the interim.

**Second Preferred Embodiment**

In a second preferred embodiment, selected clusters of lines are simultaneously excited by the use of shaped pulses, the Fourier transformations of which are designed to match the required frequency spectrum at the temperature of the object. The response from the simultaneous excitation is then detected and analysed to detect the presence of the substance.

In this embodiment a pulse sequence is used in which the pulses are shaped so that their frequency domain response has a point spread function with peaks at two or more of the NQR lines of the sample and nulls between those lines. The pulse shaping is adjusted to match the line pattern at the temperature of the sample. For the case of TNT, the frequencies of the NQR lines are calculated using equation (1) and the parameters in Table 1, or a look-up table; if a substance other than TNT is to be detected the appropriate parameters or look-up table for that substance would be used.

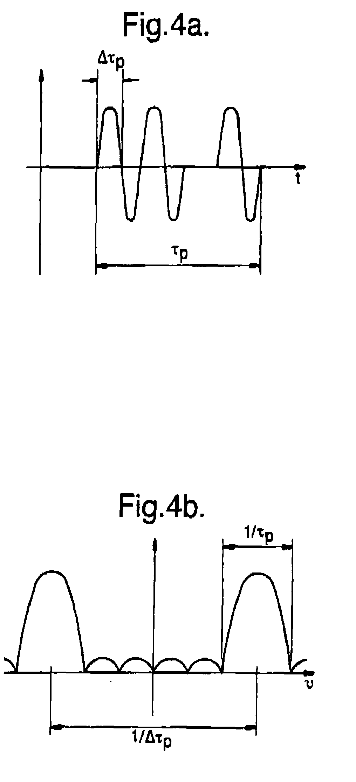

Suitable pulse shaping may be achieved by appropriate phase and amplitude modulation of the excitation pulses. For example, in order to excite two lines simultaneously, phase alternating excitation pulses may be used. In this technique each pulse of a conventional pulse sequence is replaced by a composite pulse consisting of a series of phase alternating rf pulses. Figure 4a shows an example of a typical composite pulse. The pulse consists of a plurality of individual pulses each of opposite phase to the preceding pulse. This composite pulse produces a doublet excitation spectrum in the frequency domain, each doublet having a width of $1/\tau_p$ and their maxima lying $1/\Delta\tau_p$ apart, as shown in Figure 4b.

In another technique, a set of pulses is generated, each of which would, if applied on its own, excite an individual component of the required frequency spectrum. These pulses are divided into k time segments, and then combined vectorially at each of *k* steps to produce a sequence of k vectors each with a different phase and amplitude. This sequence of vectors can be used by a digital waveform generator to generate pulses having the required frequency domain response.

Suitable pulse sequences for use in the second preferred embodiment, incorporating the individual pulses described above, will be described later.

As in the first preferred embodiment, appropriate techniques may be used to determine or estimate the temperature of the sample. For example, where the sample is buried in the ground, a probe may be inserted into the soil, or the soil temperature estimation technique described in the above mentioned paper by Hanks *et al* may be used.

For TNT, groups of lines that are particularly suited to the technique of the second preferred embodiment are shown in Table 2. The separation in frequency within each group is less than 11 kHz, and thus all of the lines in any one group may be excited using a single probe tuned to one frequency.

**Table 2**

| GROUP | LINE FREQUENCY/kHz | | | |
|---|---|---|---|---|
| 1 | 837.1 | 842.8 | 844.2 | 848.3 |
| 2 | 859.4 | 870.3 | | |
| 3 | 739.2 | 742.6 | 750.6 | |
| 4 | 713.7 | 714.3 | | |

In the second preferred embodiment, the response from a plurality of lines is detected simultaneously to give a response similar to that shown in Figure 3d. The response is first filtered to remove any beat frequencies, and then analysed using any of the techniques described with reference to the first preferred embodiment to produce a combined response in which the various NQR responses combine at a single line in the frequency domain. For instance, a phase sensitive detector may be used to demodulate each line so that all lines coincide and combine at a line in the frequency domain, or the response may be Fourier transformed into the frequency domain and each of the peaks frequency shifted such that the peaks coincide and combine, or a maximum entropy deconvolution technique may be used, or any other deconvolution or demodulation technique may be used. In general, prior knowledge of the expected frequencies of the NQR responses (as calculated for the excitation) is used to combine the responses at a single line in the frequency domain, which may be at the origin or any arbitrary point in the frequency domain.

In using these techniques, different weightings may be given to different lines in dependence, for example, on their expected strength, or other factors such as relative noise levels.

The combined response is compared to a predetermined threshold, and means may be provided for generating an alarm signal if it exceeds this threshold to indicate the presence of the substance. As in the first preferred embodiment, the response from any one particular line may be lost in noise and hence undetectable, but the combination of all of the responses in the frequency domain may produce a signal that is strong enough to be detected.

The use of simultaneous excitation together with deconvolution techniques is typically faster than sequential excitation and may produce an enhancement in the SNR.

In a variant of the second embodiment, a doubly tuned probe is used with each section of the probe tuned to a group of lines of interest. Each section of the doubly tuned probe is then fed with pulses which are suitably shaped to excite the lines within the group to which the probe is tuned. In the case of TNT, up to seven lines may be excited simultaneously using this technique (see Table 3), leading to a considerable increase in the SNR. This concept can be extended to probes with three or more tunings. For example, a coil array may be provided with each coil in the array being tuned to a particular frequency of interest. Each coil may be excited with an individual frequency, or with a group of frequencies using shaped pulses. For example, the groups of frequencies referred to in Table 2 could be excited with an array of (say) 4 or 2x2 coils.

A hybrid technique consisting of a combination of the techniques of the first and second preferred embodiments may also be used. In such a technique, the lines within any one group are excited simultaneously, and separate groups of lines are excited sequentially. The responses from the various groups are then summed to give a summed response. Further individual lines can also be excited and added to the summed response. In this way as many lines as possible may be excited using a combination of the techniques of the first and second preferred embodiments. The summed response may be analysed in any of the ways described.

**Third Preferred Embodiment**

In a third preferred embodiment groups of lines are excited simultaneously using rectangular or other pulses with a bandwidth wide enough to cover all of the lines of interest. The third preferred embodiment differs from the second preferred embodiment in that the pulses are not shaped to match the line pattern of the sample, but rather have a frequency response which is wide enough to cover all of the lines of interest. This embodiment might be preferred where the exact frequencies of the lines are not known (for instance because the exact temperature of the sample is not known), or where the lines are too close together to be able to produce a suitable point spread function.

In one example, so called "stick" excitation pulses are used. Stick excitation pulses are very narrow (in the time domain) pulses arranged to have a wide bandwidth. It may be possible to use a single stick excitation pulse to excite all of the lines of interest. Alternatively two or more stick excitation pulses could be used, each of a different frequency, to increase the bandwidth of the excitation. The stick excitation pulses would then be arranged to have substantially contiguous or overlapping responses in the frequency domain.

In another example, the pulses disclosed in International Application Number WO 92/17794 in the name of British Technology Group Limited, the subject matter of which is incorporated herein by reference, may be used. In particular, the pulses shown in Figure 3 and described on pages 17 and 18 of that document may be used. In the present embodiment, the pulses would be designed to excite all of the lines of interest.

In a further example, the pulses described in European Patent Application Number EP-A-0788608 in the name of British Technology Group Limited, the subject matter of which is incorporated herein by reference, may be used. As disclosed in that document, in one embodiment a repeating series of pulses at a plurality of frequencies are applied in a staggered, interleaved fashion. Suitable choice of pulse parameters will result in excitation having a broadband, generally rectangular response in the frequency domain. In the present embodiment, the pulse parameters are chosen to yield excitation with a bandwidth wide enough to cover all lines of interest.

As in the first and second preferred embodiments, appropriate techniques may be used to determine or estimate the temperature of the sample. For example, where the sample is buried in the ground, a probe may be inserted into the soil, or the soil temperature estimation technique described in the above mentioned paper by Hanks *et al* may be used.

As in the second preferred embodiment, the response from the simultaneous excitation is detected to give a composite response. If the frequencies of the NQR lines are known, then any of the techniques described above in relation to the second preferred embodiment may be used to detect the presence of the substance.

However, in a particular variant of the third preferred embodiment, additional processing is provided to compensate for any uncertainty in the values of the NQR frequencies due, for instance, to uncertainty in the temperature of the sample. In this refined technique mathematical processing is used to analyse the response assuming various possible temperatures of the sample. Various possible frequency responses, corresponding to various possible temperatures, are assumed, and each assumption is tested. For example, the response may be Fourier transformed into the frequency domain and, for each assumed temperature, the NQR frequencies corresponding to that temperature are frequency shifted such that all assumed NQR frequencies coincide in the frequency domain. Where the assumption about the frequencies is incorrect no combined response will be detected, since the responses will not combine correctly in the frequency domain, but where the assumption is correct, or nearly correct, a response may be detected. Alternatively, a maximum entropy deconvolution technique or any other demodulation or deconvolution technique may be used for a range of different assumed temperatures. In effect, the analysis "sweeps" through a range of possible line patterns corresponding to different temperatures.

The use of the refined technique described above avoids the need to apply several different pulse sequences for various different assumed temperatures of the sample, where the exact temperature of the sample is not known. The speed at which pulse sequences can be applied is limited by factors such as the relaxation times of the NQR responses, and repeating the pulse sequences for a range of different assumed temperatures may be highly undesirable, particularly in situations where fast detection is required. The refined technique works by applying a broad enough spread of frequencies to excite the NQR lines of interest, and then relies on processing to check whether there is a response at various different assumed temperatures.

The technique of the third preferred embodiment may also be used in combination with either or both of the techniques of the first and second preferred embodiments.

## Suitable Pulse Sequences

Any known pulse sequence may be used with the present invention, with shaping of the pulses where appropriate. For example, a Steady State Free Precession (SSFP) excitation sequence could be used. A SSFP sequence may be represented generally as follows

$$(P\alpha_{+y} - \tau)^{acq}_{n}$$

where P indicates a pulse of flip angle $\alpha$ and phase $+y$, $\tau$ is the time between pulses and n is the number of pulses. The superscript indicates that response signals are acquired for all blocks. In a particular example, $\alpha = 90°$, $y = 0°$, $\tau = 2ms$ and $n = 2000$, although other values may be used.

In another example, the phase cycled pulse sequences such as disclosed in International Patent Application Number WO 96/26453, the subject matter of which is incorporated herein by reference, may be used. WO 96/26453 discloses efficient ways of discriminating against many kinds of spurious response by using a Spin Locking (SL) pulse or a Pulsed Spin Locking (PSL) sequence. The use of an SL pulse in phase cycling is taught in the first embodiment disclosed in that document, whilst the use of a PSL sequence is taught in the second embodiment.

A typical phase cycled sequence comprises two blocks, each block having its own preparation pulse, $P_1$, followed by a sequence of identical pulses, $P_2$, differing in phase by 90° from $P_1$. In a two-block sequence, block 1 is written in general terms as

$$P\alpha_{+x} - \tau - (P\alpha_{+y}\text{-}2\tau)_m - (P\alpha_{+y}\text{-}2\tau)^{acq}_{n}$$

and block 2 is the phase-cycled version

$$P\alpha_{-x} - \tau - (P\alpha_{+y}\text{-}2\tau)_m - (P\alpha_{+y}\text{-}2\tau)^{acq}_{n}$$

In this case the preparation pulse is followed by m pulses during which response signals are not acquired, and then n pulses during which response signals are acquired.

In a further example, any of the sequences disclosed in co-pending Patent Application No. GB 9721892.9, the subject matter of which is incorporated herein by reference, may be used. The sequences disclosed in that application may be represented in general terms as

FIRST BLOCK - BRIDGING ELEMENT - SECOND BLOCK

The first block may comprise any of the following pulse sequences

$$(P\alpha_{+y} - \tau)^{acq}_{n}$$

$$P\alpha_{+x} - \tau - (P\alpha_{+y}\text{-}2\tau)_m - (P\alpha_{+y}\text{-}2\tau)^{acq}_{n}$$

$$P\alpha_{+x}\text{-}2\tau\text{-}(P\alpha_{+y}\text{-}2\tau)_m\text{-}(P\alpha_{+y}\text{-}2\tau)^{acq}_{n}$$

The bridging element following the first block may comprise any of the following elements

$$\Delta$$

$$\Delta - P\theta_{\phi}$$

$$\Delta - (P180_{\phi} - \Delta)_{n}$$

or any combination thereof, where $\Delta$ is a delay, $\theta$ is an arbitrary flip angle and $\phi$ is arbitrary phase.
The second block following the bridging element may comprise any of the following pulse sequences

$$(P\alpha_{+y} - \tau)^{acq}_{n}$$

$$P\alpha_{-x} - \tau - (P\alpha_{+y} - 2\tau)_{m} - (P\alpha_{+y} - 2\tau)^{acq}_{n}$$

$$P\alpha_{-x} - 2\tau - (P\alpha_{+y} - 2\tau)_{m} - (P\alpha_{+y} - 2\tau)^{acq}_{n}.$$

The design of suitable sequences for use with the present techniques depends upon the values of the relaxation times. In particular, the echo decay time in a multiple pulse sequence $T_{2c}$ governs the time over which an echo sequence can be maintained, and the spin-lattice relaxation time $T_1$ governs the time before which the multiple pulse sequence can be repeated.
For substances of interest, the $T_1$ and $T_{2c}$ values of the various lines may be temperature dependent. Table 3 shows some selected values of relaxation times for the 870.3 kHz line of TNT at different temperatures.

**Table 3**

| T/K | $T_1$/s | T/K | $T_{2c}$/s |
|-----|---------|-----|------------|
| 243 | 48 | | |
| 258 | 45 | 258 | 1.7 |
| 273 | 30 | 293 | 0.031 |
| 288 | 7 | 313 | 0.005 |
| 303 | 1.5 | | |
| 313 | 0.3 | | |
| 323 | 0.13 | | |

It can be seen that as the temperature rises, both $T_1$ and $T_{2e}$ shorten; for the 870.3 kHz line, they follow the relationship

$$T_1^{-1} = 2.34 \times 10^{-7} T^2 + 1.45 \times 10^{15} e^{-88,000/RT} \qquad (2)$$

and between 260 and 320 K

$$T_{2c} = 7.18 \times 10^{-12} e^{71,000/RT} \qquad (3)$$

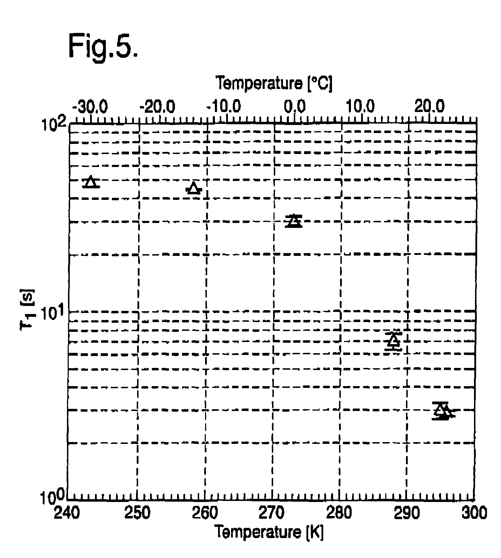

Figure 5 shows a plot of the $T_1$ relaxation time of the 870.3 kHz TNT line against frequency.

At high temperatures although $T_{2c}$ is shorter and fewer echoes may be collected and summed, $T_1$ is also shorter and the sequence may be repeated in a shorter time, so that within the total time available for the examination, the SNR may be maintained.

In programming the pulse sequence so that the excitation frequencies follow equation (I), the pulse spacings and the times between multiple pulse sequences are programmed in accordance with the relaxation times at the temperature of interest. Over certain temperature ranges, it may be possible to generalize the variations in the relaxation times for all of the lines, in which case generalized forms of equations (2) and (3), or a look-up table similar to Table 3, may be used to provide predictions of the relaxation times. However, it may be necessary to allow for the fact that different lines in the complete frequency spectrum of the sample have different values of $T_1$ and $T_{2a}$ at a given temperature, so they may still follow the general form of equations (2) and (3) but with differing coefficients. For example, the 870.3 kHz line in TNT is observed to have $T_1$ = 3s at 295K, whereas the 768.9 kHz line has a value of 16s at the same temperature.

One method of dealing with the problem in which more than one line is being detected in a predetermined cycle is to adjust the number and spacing of the pulses within a multiple-pulse sequence to allow for variations in $T_{2c}$ from one line to the next, and if a number of accumulations is being made of several such sequences in a cyclical fashion, to vary the flip angle from one line to the next according to the ratio of $2\tau/T_1$, where $2\tau$ is the multiple-pulse spacing.

**Preferred Embodiment of Apparatus**

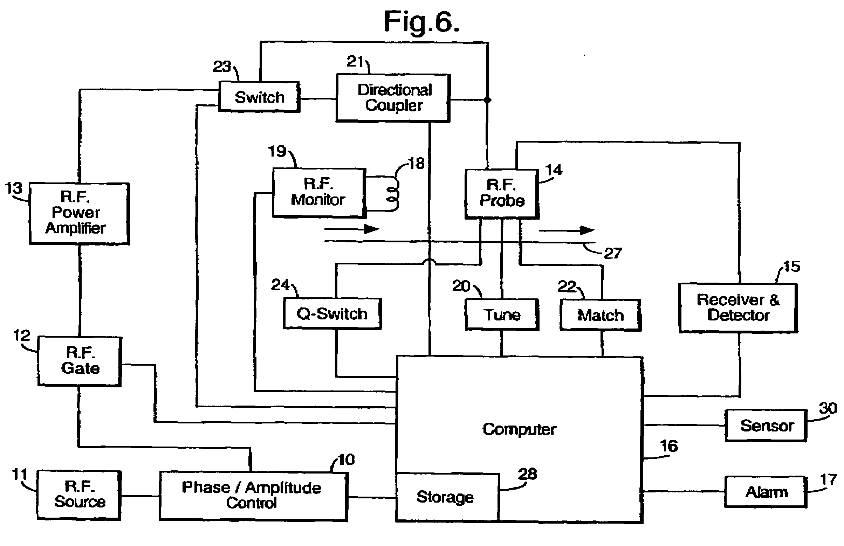

Referring to Figure 6, apparatus for NQR testing includes a radio-frequency source 11 connected via a phase/amplitude control 10 and a gate 12 to an rf power amplifier 13. The output of the latter is connected to an rf probe 14 which contains one or more rf coils disposed about or adjacent the sample to be tested (not shown), such that the sample can be irradiated with rf pulses at the appropriate frequencies to excite nuclear quadrupole resonance in the substance under test (for example, an explosive). The rf probe 14 is also connected to rf receiver and detection circuitry 15 for detecting nuclear quadrupole response signals. The detected signal is sent from circuitry 15 to a control computer 16 (or other control apparatus) for processing. The computer includes some means 17 for producing an alarm signal in dependence upon whether a response is detected. The alarm signal would normally be used to activate an audio or visual alarm to alert the operator to the presence of the substance under test. The computer also receives an input from a sensor 30, which may sense temperature, pressure, or any other environmental condition.

The computer 16 is programmed to generate excitation sequences in any of the ways described. For example, the computer may be programmed to apply a plurality of pulse sequences sequentially at different frequencies, in accordance with the first preferred embodiment. Alternatively, the computer may be programmed to apply shaped pulses in the way described with reference to the second preferred embodiment, or rectangular pulses in the way described with reference to the third preferred embodiment. Storage means 28 is provided which stores values of NQR resonances for the substance under test. The storage means 28 may store values in the form of a look up table giving values of NQR resonance frequencies for various lines at under various environmental conditions. Alternatively, the storage means 28 may store values of NQR resonance frequencies at a particular reference frequency, and coefficients which allow the values of the resonance frequencies under the environmental conditions of interest to be calculated by the computer using a polynomial fit. The storage means 28 may store values of NQR resonances for various different substances, thereby allowing the apparatus to be used for testing various different substances. The sensor 30 provides data relating to the environmental conditions which the computer may use in determining the frequency of the pulses.

The computer controls all pulses, their radio frequency, time, length, amplitude and phase. All of these parameters may need to be adjusted precisely; for example, phase may need to be varied in order to be able to generate echo responses.

The computer is also programmed to process the detected response in any of the ways described. In general the computer performs a demodulation or deconvolution technique such that the various NQR responses combine in the frequency domain. The values of the resonance frequencies calculated for the excitation are used to "collapse" all of the detected responses onto a single line in the frequency domain, to yield the combined response. If the combined response is above a certain threshold then the alarm signal is activated.

Re-tuning of the rf probe 14, alteration of its matching and alteration of its Q factor may all need to be carried out dependent upon the nature and the temperature of the sample and the NQR resonances that are to be excited. These functions are carried out by the control computer 16 as follows. Firstly, the computer checks the tuning of the rf probe 14 by means of a pick-up coil 18 and rf monitor 19, making adjustments by means of the tuning control 20. Secondly, the matching to the rf power amplifier 13 is monitored by means of a directional coupler 21 (or directional wattmeter), which the computer responds to via a matching circuit 22, which in turn adjusts the rf probe 14 by means of a variable capacitance or inductance. The directional coupler 21 is switched out by the computer 16 when not required, via switch 23. Thirdly, the Q factor of the rf coil is monitored by a frequency-switch programme and adjusted by means of a Q-switch 24 which either changes the coil Q or alternatively alerts the computer to increase the number of measurements.

Shown diagrammatically in Figure 6 and designated as 27 is some means, such as a conveyor belt, for transporting a succession of samples to a region adjacent the rf probe 14. The computer 16 is arranged to time the application of the excitation pulses substantially simultaneously with the arrival of a particular sample adjacent the probe. In alternative embodiments, instead of the sample being carried on a conveyor belt, it may actually be a person, and the rf probe may be in the form of a walk-through gateway or a hand-held wand, or the probe itself may be moved over terrain at a predetermined rate.

As was described above, the radio-frequency probe may utilise a single coil for both transmission and reception of signals, or any appropriate number of coils may be used.

Different coils can be used for transmission and reception. Other types of probe such as a plane antenna or surface coil, or a single-beam probe such as a loop-gap resonator may also be used.

The apparatus would usually operate in the absence of any applied magnetic field.

### Preferred method of operation

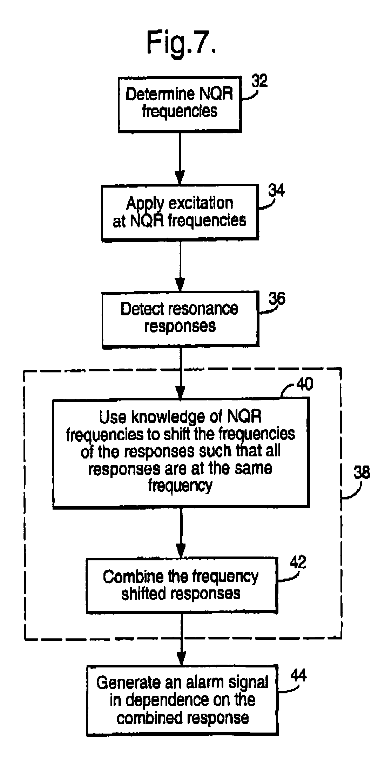

Figure 7 shows a flow diagram of a preferred method of operation. In a first stage 32, values of NQR frequencies for the substance to be tested are determined, using a look up table or a polynomial fit. In a second stage 34, excitation is applied at the NQR frequencies. The excitation may be applied sequentially as in the first preferred embodiment or simultaneously as in the second and third preferred embodiments. In a third stage 36 the resonance responses to the excitation are detected.

In a processing stage 38 the resonance responses are processed to yield a combined response. In this example, the processing stage 38 consists of a shifting stage 40, in which knowledge of NQR frequencies is used to shift the frequencies of the responses such that all responses are at the same frequency, and a combining stage 42, in which the frequency shifted responses are combined. In general, the processing stage 38 may use any of the processing techniques described herein, such as demodulation or deconvolution techniques, to yield the combined response.

In an alarm stage 44, an alarm signal is generated in dependence on the combined response, for instance by comparing it to a predetermined threshold.

### Maximum entropy method

The maximum entropy method consists of finding the spectrum $F(\omega)$ which maximises a suitably defined entropy, $S$, consistent with the observed time domain data $d_1$. The latter constraint is usually expressed in terms of a $\chi^2$ parameter of the form

$$\chi^2 = \sum \frac{|d_i - D_i|^2}{\sigma_i^2}$$

where $D_i$ is the time domain signal predicted by $F(\omega)$, $\sigma_1$ is the statistical uncertainty in $d_o$ and the summation runs over the available time-domain data points. The spectrum is judged to be consistent with the data when $\chi^2$ has some particular value, for example equal to the number of data points $N$, or approaches zero. The problem then is to find the spectrum that maximizes $S - \lambda\chi^2$ where $\lambda$ is a Lagrange multiplier such that $\chi^2$ has the required value.

The entropy S of the spectrum is defined as

$$S = \sum \left[ -F(\omega) \log(F(\omega)) \right].$$

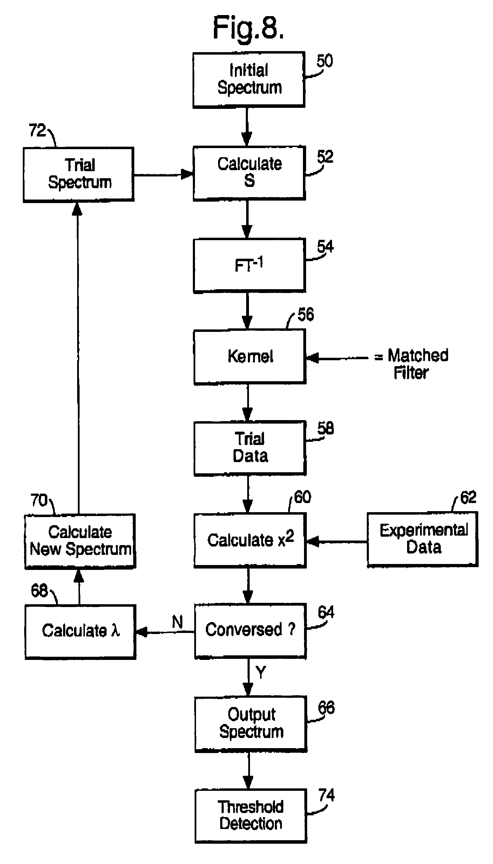

Figure 8 shows the main elements of a maximum entropy method that may be used with the preferred embodiments. Referring to Figure 8, the algorithm takes as an input an initial trial spectrum 50, which may be null, or may include some prior knowledge of the response. In step 52, the entropy $S$ is obtained according to the above formula. In step 54 the inverse Fourier Transformation is applied to the spectrum to obtain a time domain representation of the trial spectrum. In step 56 the time domain representation is multiplied by a filter function to obtain the trial data 58. The filter function represents the expected spectrum of the resonance response signal. In the present case, where there are multiple frequencies, $\Omega_k$, in the spectrum, which are all in phase at the peak of the signal, and have amplitudes $A_k$, then the filter $f(j,t)$ has the same form as the complex conjugate of the signal. For echo trains, the filter takes the form;

$$f(j,t) = \sum A_k \exp[-B_k(t+j\tau)]\exp(-C_k|t|)\exp(-i\Omega_k t)$$

for the $j^{th}$ response (for example, an echo), where $t$ is time, $\tau$ is the spacing between echoes and B and C are decay constants for the individual echo and the echo train respectively. For f.i.d.'s, $\tau=0$.

In step 60 the value of $\chi^2$ is calculated from the trial data 58 and the experimental data 62. In step 64, it is determined whether $S - \lambda\chi^2$ has been maximized. If so then the algorithm is taken as converged and the trial spectrum is taken as the output spectrum. Otherwise, in step 68 the value of $\lambda$ is calculated, in step 70 a new trial spectrum 72 is calculated, and the process is repeated.

Once the algorithm has converged, in step 74 the output spectrum 66 is subjected to threshold detection to determine the presence of the sample. If the signal is determined to be present, then an alarm signal is generated.

The effect of applying the maximum entropy method with a filter function, as described above, is to deconvolve multiple peaks that occur in the resonance response signal into a single peak, using prior knowledge of the location of the peaks. In this way, multiple peaks which may have low individual low signal to noise ratios can be deconvolved into a single peak with higher signal to noise ratio, and thus the presence of the substance may be detected with greater certainty.

It will be understood that the present invention has been described above purely by way of example, and modifications of detail can be made within the scope of the invention.

For simplicity the preferred embodiments have been described with reference to the particular case of testing the explosive TNT. However, it will be appreciated that TNT is described purely as an example, and the teachings herein are not limited to the detection of TNT but may be used for testing any substance displaying two or more NQR resonances, particularly, but not exclusively, where the resonances are weak. For example the techniques of the present invention could also be used for testing the explosive RDX which displays adjacent $^{14}$N lines at 1783 kHz and 1786 kHz at 286 K.

Furthermore, although the preferred embodiments are directed to detecting the presence of substances such as TNT, the techniques disclosed could also be used for other types of testing, such a imaging. In this case the processing techniques would produce quantitative data relating to the strength of the combined NQR response.

Each feature disclosed in the description, and (where appropriate) the claims and drawings may be provided independently or in any appropriate combination.

Any reference numerals appearing in the claims are by way of illustration only and shall have no limiting effect on the scope of the claims.

In conclusion, the present invention provides for the following features, as defined in the claims of the parent application:

1. Apparatus for Nuclear Quadrupole Resonance testing a sample, comprising:

applying means for applying excitation to the sample to excite nuclear quadrupole resonance at a plurality of different nuclear quadrupole resonance frequencies;
detecting means for detecting the resonance responses to the excitation at the plurality of frequencies; and
processing means for processing the resonance responses at the plurality of frequencies to yield a combined response.

2. Apparatus according to feature 1 wherein the processing means is adapted to process the resonance responses such that their frequencies would appear shifted towards one another in the frequency domain.

3. Apparatus according to feature 1 or 2 wherein the processing means is adapted to have the effect of shifting a respective resonance response peak associated with each said resonance response towards one another to yield as the combined response a response having a smaller number of peaks.

4. Apparatus according to any of the preceding features wherein the processing means is adapted to process the resonance responses such that their frequencies would appear superposed in the frequency domain.

5. Apparatus according to any of the preceding features wherein the processing means is adapted to process the resonance responses such that their frequencies would appear substantially to coincide in the frequency domain.

6. Apparatus according to any of the preceding features wherein the processing means comprises means for demodulating or deconvoluting the resonance responses to yield the combined response.

7. Apparatus according to any of the preceding features wherein the processing means comprises a filter, matched to expected frequencies of the resonance responses, for filtering the resonance responses.

8. Apparatus according to feature 7 wherein the processing means further comprises means for transforming the filtered signals into the frequency domain.

9. Apparatus according to any of the preceding features wherein the processing means comprises means for performing a maximum entropy deconvolution technique.

10. Apparatus according to feature 9 wherein the maximum entropy deconvolution technique is a maximum entropy method which includes a filter matched to expected frequencies of the resonance response signals.

11. Apparatus according to any of the preceding features wherein the processing means comprises a phase sensitive detector.

12. Apparatus according to any of the preceding features wherein the processing means is adapted to transform the resonance responses into the frequency domain, to shift the frequencies of the thus transformed resonance responses, and to combine the thus shifted resonance responses to yield the combined response.

13. Apparatus according to any of the preceding features further comprising determining means for determining predetermined values of nuclear quadrupole resonance frequencies.

14. Apparatus according to feature 13 wherein the processing means is adapted to process the resonance responses in dependence on the predetermined values of nuclear quadrupole resonance frequencies.

15. Apparatus according to feature 13 or 14 further comprising means for sensing an environmental parameter, wherein the determining means is adapted to determine the predetermined values of nuclear quadrupole resonance frequencies in dependence on known variations of nuclear quadrupole resonance frequencies with the environmental parameter.

16. Apparatus according to any of features 13 to 15 wherein the determining means is adapted to determine the predetermined values of nuclear quadrupole resonance frequencies using a polynomial fit or a look-up table,

17. Apparatus according to any of features 13 to 16 wherein the determining means is adapted to determine the predetermined values of nuclear quadrupole resonance frequencies substantially according to the following formula

$$\upsilon_Q = \upsilon_0 - a\,T$$

where $\upsilon_Q$ is the frequency to be selected, $T$ is temperature and $a$ and $\upsilon_0$ are selected from the following table:-

| $\upsilon_0$/ kHz | $a$/ kHzT$^{-1}$ |
|---|---|
| 901 | 0.10 |
| 921 | 0.21 |
| 894 | 0.15 |
| 876 | 0.11 |
| 893 | 0.17 |
| 870 | 0.11 |
| 821 | 0.18 |
| 820 | 0.23 |
| 783 | 0.14 |
| 787 | 0.16 |
| 740 | 0.09 |
| 741 | 0.09 |

18. Apparatus according to any of features 13 to 16 wherein the predetermined values of nuclear quadrupole resonance frequencies comprise 1783 kHz and 1786 kHz at 286 K.

19. Apparatus according to any of features 13 to 18 wherein the applying means is adapted to apply excitation at the predetermined values of nuclear quadrupole resonance frequencies.

20. Apparatus according to any of the preceding features wherein the applying means is adapted to apply excitation to excite the plurality of nuclear quadrupole resonance frequencies sequentially.

21. Apparatus according to feature 20 further comprising means for summing the responses to the excitation to yield a summed response, wherein the processing means is adapted to process the summed response to yield the combined response.

22. Apparatus according to feature 20 wherein the processing means is adapted to shift the frequencies of the responses to said excitation to yield frequency shifted responses, and to sum the frequency shifted responses to yield the combined response.

23. Apparatus according to any of the preceding features wherein the applying means is adapted to apply excitation to excite the plurality of nuclear quadrupole resonance frequencies simultaneously.

24. Apparatus according to feature 23 wherein the applying means is adapted to apply excitation pulses with a bandwidth including the predetermined values of nuclear quadrupole resonance frequencies.

25. Apparatus according to feature 23 or 24 wherein the applying means is adapted to apply excitation pulses which exhibit at least two peaks in the frequency domain.

26. Apparatus according to any of features 23 to 25 wherein the applying means is adapted to apply further excitation sequentially predetermined nuclear quadrupole resonance frequency.

27. Apparatus according to any of the preceding features wherein the applying means is adapted to apply a plurality of excitation pulses, wherein the time between successive excitation pulses is less than 5 times the $T_1$ value of the relevant nuclear quadrupole resonance, preferably less than 3, 2, 1, 0.5, 0.3, 0.2 or 0.1 times.

28. Apparatus according to any of the preceding features, wherein the applying means comprises a plurality of antennas.

29. Apparatus according to feature 28 wherein each antenna is tuned to a different resonant frequency.

30. Apparatus according to any of the preceding features, wherein the detecting means comprises a plurality of antennas.

31. Apparatus according to any of the preceding features further comprising means for providing an alarm signal in dependence upon the combined response.

32. Apparatus according to any of the preceding features, being apparatus for detecting the presence of a substance containing a given species of quadrupolar nucleus.

33. Apparatus according to any of features 1 to 17 or 19 to 32, wherein the applying means is adapted to apply excitation to excite a plurality of resonances selected from the following table:-

| FREQUENCY AT 293K / kHz |
|---|
| 870 |
| 859 |
| 848 |
| 844 |
| 843 |
| 837 |
| 769 |
| 751 |
| 743 |
| 739 |
| 714.3 |
| 713.7 |

34. Apparatus for detecting the presence in a sample of a substance containing quadrupolar nuclei, comprising applying means for applying to the sample excitation to excite a plurality of resonances selected from the following table:-

| FREQUENCY AT 293K / kHz |
|---|
| 870 |
| 859 |
| 848 |
| 844 |

(continued)

| FREQUENCY AT 293K / kHz |
|---|
| 843 |
| 837 |
| 769 |
| 751 |
| 743 |
| 739 |
| 714.3 |
| 713.7 |

35. Apparatus according to feature 33 or 34 wherein said applying means is adapted to excite at least one of the 843 kHz, the 844 kHz, the 739 kHz and the 713.7 kHz resonances.

36. Apparatus according to any of features 1 to 17 or 19 to 35 wherein the applying means is adapted to apply excitation to excite resonances in at least one of the following groups:-

| GROUP | FREQUENCY AT 293K/ kHz | | | |
|---|---|---|---|---|
| 1 | 837 | 843 | 844 | 848 |
| 2 | 859 | 870 | | |
| 3 | 739 | 743 | 751 | |
| 4 | 713.7 | 714.3 | | |

37. Apparatus according to any of features 33 to 36 further comprising storage means for storing values of NQR resonances.

38. Apparatus according to any of features 33 to 37 further comprising determining means for determining values of NQR resonances.

39. Apparatus according to feature 38 further comprising means for sensing an environmental parameter.

40. Apparatus according to feature 39 wherein the determining means is adapted to determine the values of NQR resonances in dependence on the environmental parameter.

41. Apparatus according to any of features 33 to 40 further comprising means for detecting the resonance responses to the excitation, and means for providing an alarm signal in dependence on the detected response.

42. A method of Nuclear Quadrupole Resonance testing a sample, comprising the steps of:

applying excitation to the sample to excite nuclear quadrupole resonance at a plurality of different nuclear quadrupole resonance frequencies;
detecting the resonance responses to the excitation at the plurality of frequencies; and
processing the resonance responses at the plurality of frequencies to yield a combined response.

43. A method according to feature 42 wherein the step of processing comprises processing the resonance responses such that their frequencies would appear shifted towards one another in the frequency domain.

44. A method according to feature 42 or 43 wherein the step of processing has the effect of shifting a resonance response peak associated with each said resonance response towards one another to yield as the combined response a response having a smaller number of peaks.

45. A method according to any of features 42 to 44 wherein the step of processing comprises processing the resonance responses would appear superposed in the frequency domain.

46. A method according to any of features 42 to 45 wherein the step of processing comprises processing the resonance responses such that their frequencies would appear substantially to coincide in the frequency domain.

47. A method according to any of features 42 to 46 wherein the step of processing comprises demodulating or deconvoluting the resonance responses to yield the combined response.

48. A method according to any of features 42 to 47 wherein the step of processing comprises filtering the resonance responses with a filter matched to expected frequencies of the resonance responses.

49. A method according to feature 48 wherein the step of processing further comprises transforming the filtered signals into the frequency domain.

50. A method according to any of features 42 to 49 wherein the step of processing comprises performing a maximum entropy deconvolution technique.

51. A method according to feature 50 wherein the maximum entropy deconvolution technique is a maximum entropy method which includes a filter matched to expected frequencies of the resonance response signals.

52. A method according to any of features 42 to 51 wherein the step of processing comprises phase sensitive detection.

53. A method according to any of features 42 to 52 wherein the step of processing comprises transforming the resonance responses into the frequency domain, shifting the frequencies of the thus transformed resonance responses, and combining the thus shifted resonance responses to yield the combined response.

54. A method according to any of features 42 to 53 further comprising determining predetermined values of nuclear quadrupole resonance frequencies.

55. A method according to feature 54 wherein the step of processing 5 comprises processing the resonance responses in dependence on the predetermined values of nuclear quadrupole resonance frequencies.

56. A method according to feature 54 or 55 further comprising sensing an environmental parameter, whereby the step of determining comprises determining predetermined values of nuclear quadrupole resonance frequencies in dependence on known variations of nuclear quadrupole resonance frequencies with the environmental parameter.

57. A method according to any of features 54 to 56 wherein the step of determining comprises determining the predetermined values of nuclear quadrupole resonance frequencies using a polynomial fit or a look-up table.

58. A method according to any of features 54 to 57 wherein the step of determining comprises determining the predetermined values of nuclear quadrupole resonance frequencies substantially according to the following formula

$$\nu_Q = \nu_0 - a\,T$$

where $\nu_Q$ is the frequency to be selected, $T$ is temperature and $a$ and $\nu_0$ are selected from the following table:-

| $\nu_0$/ kHz | $a$ / kHzT$^{-1}$ |
|---|---|
| 901 | 0.10 |
| 921 | 0.21 |
| 894 | 0.15 |
| 876 | 0.11 |
| 893 | 0.17 |
| 870 | 0.11 |
| 821 | 0.18 |
| 820 | 0.23 |
| 783 | 0.14 |
| 787 | 0.16 |
| 740 | 0.09 |
| 741 | 0.09 |

59. A method according to any of features 54 to 57 wherein the predetermined values of nuclear quadrupole resonance frequencies comprise 1783 kHz and 1786 kHz at 286 K.

60. A method according to any of features 54 to 59 wherein the step of applying excitation comprises applying excitation at the predetermined values of nuclear quadrupole resonance frequencies.

61. A method according to any of features 42 to 60 wherein the step of applying excitation comprises applying excitation to excite the plurality of nuclear quadrupole resonance frequencies sequentially.

62. A method according to feature 61 wherein the step of processing comprises summing the responses to the excitation to yield a summed response, and processing the summed response to yield the combined response.

63. A method according to feature 61 wherein the step of processing comprises shifting the frequencies of the responses to said excitation to yield frequency shifted responses, and summing the frequency shifted responses to yield the combined response.

64. A method according to any of features 42 to 60 wherein the step of applying excitation comprises applying excitation at the predetermined values of nuclear quadrupole resonance frequencies simultaneously.

65. A method according to feature 64 wherein the step of applying excitation comprises applying excitation pulses with a bandwidth including the predetermined values of nuclear quadrupole resonance frequencies.

66. A method according to feature 64 or 65 wherein the step of applying excitation comprises applying excitation pulses which exhibit at least two peaks in the frequency domain.

67. A method according to any of features 64 to 66 wherein the step of applying excitation comprises applying further excitation sequentially at at least one further predetermined nuclear quadrupole resonance frequency.

68. A method according to any of features 42 to 67 wherein the step of applying excitation comprises applying a plurality of excitation pulses, the time between successive excitation pulses being less than 5 times the $T_1$ value of the relevant nuclear quadrupole resonance, preferably less than 3, 2, 1, 0.5, 0.3, 0.2 or 0.1 times.

69. A method according to any of features 42 to 68 further comprising providing an alarm signal in dependence upon the combined response.

70. A method according to any of features 42 to 69 being a method of detecting the presence of a substance containing a given species of quadrupolar nucleus.

71. A method according to any of features 42 to 58 or 60 to 70, wherein the step of applying excitation comprises applying excitation to excite a plurality of resonances selected from the following table:-

| FREQUENCY AT 293K / kHz |
|---|
| 870 |
| 859 |
| 848 |
| 844 |
| 843 |
| 837 |
| 769 |
| 751 |
| 743 |
| 739 |
| 714.3 |
| 713.7 |

72. A method for detecting the presence in a sample of a substance 20 containing quadrupolar nuclei, comprising applying to the sample excitation to excite a plurality of resonances selected from the following table:-

| FREQUENCY AT 293K / kHz |
|---|
| 870 |
| 859 |
| 848 |
| 844 |
| 843 |
| 837 |
| 769 |
| 751 |
| 743 |

(continued)

| FREQUENCY AT 293K / kHz |
|---|
| 739 |
| 714.3 |
| 713.7 |

73. A method according to feature 71 or 72 wherein the step of applying excitation comprises exciting at least one of the 843 kHz, the 844 kHz, the 739 kHz and the 713.7 kHz resonances.

74. A method according to any of features 42 to 58 or 60 to 73 wherein the step of applying excitation comprises applying excitation to excite resonances in at least one of the following groups:-

| GROUP | FREQUENCY AT 293K/ kHz | | | |
|---|---|---|---|---|
| 1 | 837 | 843 | 844 | 848 |
| 2 | 859 | 870 | | |
| 3 | 739 | 743 | 751 | |
| 4 | 713.7 | 714.3 | | |

75. A method according to any of features 71 to 74 further comprising storing values of NQR resonances.

76. A method according to any of features 71 to 75 further comprising determining values of NQR resonances.

77. A method according to feature 76 further comprising sensing an environmental parameter.

78. A method according to feature 77 wherein the step of determining comprises determining the values of NQR resonances in dependence on the environmental parameter.

79. A method according to any of features 71 to 78 further comprising detecting the resonance responses to the excitation, and providing an alarm signal in dependence on the detected response.

80. Apparatus or method substantially as herein described with reference to the accompanying drawings.

**Claims**

1. Apparatus for Nuclear Quadrupole Resonance testing a sample, comprising:

   applying means for applying excitation to the sample to excite nuclear quadrupole resonance at a plurality of different nuclear quadrupole resonance frequencies;
   detecting means for detecting the resonance responses to the excitation at the plurality of frequencies; and
   processing means for processing the resonance responses at the plurality of frequencies to yield a combined response.

2. Apparatus according to claim 1 further comprising means for providing an alarm signal in dependence upon the combined response.

3. Apparatus according to claim 1 or claim 2, being apparatus for detecting the presence of a substance containing a given species of quadrupolar nucleus.

4. Apparatus according to any of claims 1 to 3, wherein the applying means is adapted to apply excitation to excite a plurality of resonances selected from the following table:-

| FREQUENCY AT 293K / kHz |
|---|
| 870 |
| 859 |
| 848 |

(continued)

| FREQUENCY AT 293K / kHz |
| --- |
| 844 |
| 843 |
| 837 |
| 769 |
| 751 |
| 743 |
| 739 |
| 714.3 |
| 713.7 |

5. Apparatus according to any of the preceding claims wherein the processing means is adapted to process the resonance responses such that their frequencies would appear shifted towards one another in the frequency domain.

6. Apparatus according to any of the preceding claims wherein the processing means is adapted to have the effect of shifting a respective resonance response peak associated with each said resonance response towards one another to yield as the combined response a response having a smaller number of peaks, and/or
wherein the processing means is adapted to process the resonance responses such that their frequencies would appear superposed in the frequency domain, and/or
wherein the processing means is adapted to process the resonance responses such that their frequencies would appear substantially to coincide in the frequency domain.

7. Apparatus according to any of the preceding claims wherein the processing means comprises means for demodulating or deconvoluting the resonance responses to yield the combined response.

8. Apparatus according to any of the preceding claims wherein the processing means comprises a filter, matched to expected frequencies of the resonance responses, for filtering the resonance responses, and preferably the processing means further comprises means for transforming the filtered signals into the frequency domain.

9. Apparatus according to any of the preceding claims wherein the processing means comprises means for performing a maximum entropy deconvolution technique, and preferably the maximum entropy deconvolution technique is a maximum entropy method which includes a filter matched to expected frequencies of the resonance response signals.

10. Apparatus according to any of the preceding claims wherein the processing means comprises a phase sensitive detector.

11. Apparatus according to any of the preceding claims wherein the processing means is adapted to transform the resonance responses into the frequency domain, to shift the frequencies of the thus transformed resonance responses, and to combine the thus shifted resonance responses to yield the combined response.

12. Apparatus according to any of the preceding claims further comprising determining means for determining predetermined values of nuclear quadrupole resonance frequencies, and preferably wherein the processing means is adapted to process the resonance responses in dependence on the predetermined values of nuclear quadrupole resonance frequencies.

13. Apparatus according to claim 12 further comprising means for sensing an environmental parameter, wherein the determining means is adapted to determine the predetermined values of nuclear quadrupole resonance frequencies in dependence on known variations of nuclear quadrupole resonance frequencies with the environmental parameter.

14. Apparatus according to claim 12 or claim 13 wherein the determining means is adapted to determine the predetermined values of nuclear quadrupole resonance frequencies using a polynomial fit or a look-up table.

**15.** Apparatus according to any of claims 12 to 14 wherein the determining means is adapted to determine the predetermined values of nuclear quadrupole resonance frequencies substantially according to the following formula

$$\upsilon_Q = \upsilon_0 - a\,T$$

where $\upsilon_Q$ is the frequency to be selected, $T$ is temperature and $a$ and $\upsilon_0$ are selected from the following table:-

| $\upsilon_0$/kHz | $a$/kHzT$^{-1}$ |
|---|---|
| 901 | 0.10 |
| 921 | 0.21 |
| 894 | 0.15 |
| 876 | 0.11 |
| 893 | 0.17 |
| 870 | 0.11 |
| 821 | 0.18 |
| 820 | 0.23 |
| 783 | 0.14 |
| 787 | 0.16 |
| 740 | 0.09 |
| 741 | 0.09 |

**16.** Apparatus according to any of claims 12 to 14 wherein the predetermined values of nuclear quadrupole resonance frequencies comprise 1783 kHz and 1786 kHz at 286 K.

**17.** Apparatus according to any of claims 12 to 16 wherein the applying means is adapted to apply excitation at the predetermined values of nuclear quadrupole resonance frequencies.

**18.** Apparatus according to any of the preceding claims wherein the applying means is adapted to apply excitation to excite the plurality of nuclear quadrupole resonance frequencies sequentially, the apparatus preferably further comprising
means for summing the responses to the excitation to yield a summed response, wherein the processing means is adapted to process the summed response to yield the combined response, or
wherein the processing means is adapted to shift the frequencies of the responses to said excitation to yield frequency shifted responses, and to sum the frequency shifted responses to yield the combined response.

**19.** Apparatus according to any of the preceding claims wherein the applying means is adapted to apply excitation to excite the plurality of nuclear quadrupole resonance frequencies simultaneously, and preferably wherein the applying means is adapted to apply excitation pulses with a bandwidth including the predetermined values of nuclear quadrupole resonance frequencies.

**20.** Apparatus according to claim 19 wherein the applying means is adapted to apply excitation pulses which exhibit at least two peaks in the frequency domain, and/or wherein the applying means is adapted to apply further excitation sequentially predetermined nuclear quadrupole resonance frequency.

**21.** Apparatus according to any of the preceding claims wherein the applying means is adapted to apply a plurality of excitation pulses, wherein the time between successive excitation pulses is less than 5 times the $T_1$ value of the relevant nuclear quadrupole resonance, preferably less than 3, 2, 1, 0.5, 0.3, 0.2 or 0.1 times.

**22.** Apparatus according to any of the preceding claims, wherein the applying means comprises a plurality of antennas, preferably each antenna is tuned to a different resonant frequency, and/or wherein the detecting means comprises a plurality of antennas.

23. Apparatus for detecting the presence in a sample of a substance containing quadrupolar nuclei, comprising applying means for applying to the sample excitation to excite a plurality of resonances selected from the following table:-

| FREQUENCY AT 293K / kHz |
| --- |
| 870 |
| 859 |
| 848 |
| 844 |
| 843 |
| 837 |
| 769 |
| 751 |
| 743 |
| 739 |
| 714.3 |
| 713.7 |

24. Apparatus according to claim 4 or 23 wherein said applying means is adapted to excite at least one of the 843 kHz, the 844 kHz, the 739 kHz and the 713.7 kHz resonances, and/or wherein the applying means is adapted to apply excitation to excite resonances in at least one of the following groups:-

| GROUP | FREQUENCY AT 293K/ kHz | | | |
| --- | --- | --- | --- | --- |
| 1 | 837 | 843 | 844 | 848 |
| 2 | 859 | 870 | | |
| 3 | 739 | 743 | 751 | |
| 4 | 713.7 | 714.3 | | |

25. A method of Nuclear Quadrupole Resonance testing a sample, comprising the steps of:

applying excitation to the sample to excite nuclear quadrupole resonance at a plurality of different nuclear quadrupole resonance frequencies;
detecting the resonance responses to the excitation at the plurality of frequencies; and
processing the resonance responses at the plurality of frequencies to yield a combined response.

26. A method for detecting the presence in a sample of a substance 20 containing quadrupolar nuclei, comprising applying to the sample excitation to excite a plurality of resonances selected from the following table:-

| FREQUENCY AT 293K / kHz |
| --- |
| 870 |
| 859 |
| 848 |

(continued)

| FREQUENCY AT 293K / kHz |
| --- |
| 844 |
| 843 |
| 837 |
| 769 |
| 751 |
| 743 |
| 739 |
| 714.3 |
| 713.7 |

# Fig.1.

| △ 870.3 kHz | 899.630-0.0991 *T |
| X 860.4 kHz (16 °C) | 920.253-0.2067 *T |
| ■ 848.3 kHz | 892.045-0.1474 *T |
| □ 844.2 kHz | 874.426-0.1022 *T |
| x 842.8 kHz | 890.453-0.1609 *T |
| * 837.1 kHz | 868.903-0.1073 *T |

# Fig.2.

| | |
|---|---|
| △ 768.8 kHz | 819.591-0.1715 *T |
| X 750.6 kHz | 835.700-0.2875 *T |
| ■ 742.6 kHz | 782.862-0.1354 *T |
| □ 739.2 kHz | 786.862-0.1604 *T |
| x 714.3 kHz | 739.967-0.0865 *T |
| o 713.7 kHz | 742.013-0.0956 *T |

Fig.3a.

Noise

$f_1$

Fig.3b.

Noise

$f_2$

Fig.3c.

Noise

$f_3$

Fig.3d.

Noise

$f_1$ $f_2$ $f_3$

Fig.3e.

Noise

$f_4$

# Fig.4a.

$$\Delta \tau_p$$

$$t$$

$$\tau_p$$

# Fig.4b.

$$1/\tau_p$$

$$\upsilon$$

$$1/\Delta\tau_p$$

# Fig.5.

# Fig.6.

EP 1 801 607 A2

# Fig.7.

```
┌─────────────────────┐
│  Determine NQR      │ 32
│  frequencies        │
└─────────────────────┘
          │
          ▼
┌─────────────────────┐
│   Apply excitation  │ 34
│ at NQR frequencies  │
└─────────────────────┘
          │
          ▼
┌─────────────────────┐
│  Detect resonance   │ 36
│     responses       │
└─────────────────────┘
          │
┌ ─ ─ ─ ─ ─ ─ ─ ─ ─ ─ ─ ─ ─ ─ ┐
    ┌─────────────────────┐ 40
│   │  Use knowledge of NQR│       │
    │frequencies to shift the frequencies│
│   │ of the responses such that all│     │
    │ responses are at the same│      38
│   │      frequency       │       │
    └─────────────────────┘
│            │                    │
             ▼
│   ┌─────────────────────┐ 42    │
    │ Combine the frequency│
│   │  shifted responses   │       │
    └─────────────────────┘
└ ─ ─ ─ ─ ─ ─ ─ ─ ─ ─ ─ ─ ─ ─ ─ ─ ┘
          │
          ▼
┌─────────────────────┐
│ Generate an alarm signal│ 44
│  in dependence on the │
│  combined response    │
└─────────────────────┘
```

# Fig.8.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- GB 2286248 A
- GB 2289344 A
- WO 9217794 A
- EP 0788608 A
- WO 9626453 A
- GB 9721892 A

### Non-patent literature cited in the description

- **HANKS et al.** Soil Temperature Estimation by a Numerical Method. *Soil Science Society of America Proceedings,* September 1971, vol. 35 (5